# EUROPÄISCHE PATENTANMELDUNG

(11) **EP 2 544 231 A2**
(43) Veröffentlichungstag der Anmeldung: **09.01.2013**
(21) Anmeldenummer: 12168155.5
(22) Anmeldetag: 16.05.2012
(51) Int. Cl.: H01L 25/07, H01L 23/18, H01L 23/498

(54) **Leistungselektronisches System mit einer Kühleinrichtung**

(30) Priorität: 07.07.2011 DE 102011078806
(71) Anmelder: SEMIKRON Elektronik GmbH & Co. KG, 90431 Nürnberg (DE)
(72) Erfinder: Besendörfer, Kurt-Georg, 90556 Cadolzburg (DE); Erdner, Nadja, 91227 Leinburg (DE); Steger, Jürgen, 91355 Hiltpoltstein (DE)

(57) **Zusammenfassung**

Die Anmeldung betrifft ein leistungselektronisches System sowie ein Herstellungsverfahren mit einer Kühleinrichtung, einer Mehrzahl von ersten flächigen Isolierstoffkörpern, einer Mehrzahl von ersten Leiterbahnen mindestens einem Leistungshalbleiterbauelement, mindestens einer internen Verbindungseinrichtung und externen Anschlusselementen. Die Isolierstoffkörper sind hierbei stoff- oder kraftschlüssig und voneinander beabstandet mit ihrer ersten Hauptfläche auf der Kühleinrichtung angeordnet. Mindestens eine erste Leiterbahn bedeckt zwei erste Isolierstoffkörper auf deren zweiter Hauptfläche zumindest teilweise und überdeckt hierbei einen Zwischenraum zwischen den ersten Isolierstoffkörpern mit mindestens einem Verbindungsabschnitt.

## Beschreibung

Die Erfindung beschreibt ein leistungselektronisches System, vorzugsweise zur Ausbildung einer damit realisierten Schaltungsanordnung in Form eines Stromrichters, beispielhaft eines Drei-Phasen-Wechselrichters. Derartige Systeme sind beispielhaft als Leistungshalbleitermodule mit Grundplatte oder als Anordnungen eines Leistungshalbleitermoduls ohne Grundplatte mit einer Kühleinrichtung bekannt.

Aus der DE 10 2009 045 181 A1 sind derartige leistungselektronische System bekannt, die hier aus einem Gleich- und einem Wechselrichter in einem gemeinsamen Gehäuse aufgebaut sind. Um unterschiedlichen Anforderungen gerecht zu werden, weist dieses System zwei Substrate auf, die jeweils aus einem Isolierstoffkörper mit Metallkaschierungen auf beiden Hauptflächen ausgebildet sind. Die jeweiligen dem Inneren des Systems zugewandte Seite des Substrats weist hier eine Strukturierung der Metallkaschierung auf, die somit eine Mehrzahl von Leiterbahnen ausbildet.

Eine grundlegende Anforderung an alle gattungsgemäßen leistungselektronischen Systeme ist es die Wärme, die aus der Verlustleistung der Leistungshalbleiterbauelemente resultiert, aus dem System auf oder über die Kühleinrichtung abzuführen. Hierbei ist noch zu berücksichtigen, dass die Systeme im Betrieb zyklischen Temperaturänderungen unterworfen sind. Diese Temperarturschwankungen beanspruchen die Verbindungen verschiedener Komponenten des leistungselektronischen Systems zueinander insbesondere, wenn diese unterschiedliche thermische Ausdehnungskoeffizienten aufweisen.

Ziel allfälliger Bemühungen in der Konstruktion derartiger leistungselektronsicher Systeme ist es daher thermisch bedingte mechanische Belastungen zu kompensieren und damit die Dauerhaltbarkeit und alternativ oder bevorzugt gleichzeitig die thermische Belastbarkeit zu steigern. Aus der DE 10 2006 011 995 A1 ist es hierfür bekannt die Grundplatte eines Leistungshalbleitermoduls auf verschiedene Arten zu segmentieren, zum Teil auch vollständig zu unterbrechen, um hiermit die Anbindung an eine weitere Kühleinrichtung zu verbessern. Die DE 197 07 514 A1 schlägt zu einer Segmentierung zusätzlich vor die einzelnen Grundplattenabschnitte mit einer Vorbiegung zu versehen.

Der Erfindung liegt somit die Aufgabe zugrunde ein leistungselektronisches System vorzustellen, das eine bezüglich ihrer thermischen Ankopplung und ihrer Dauerhaltbarkeit verbesserte Verbindung der Leistungshalbleiterbauelement zu einer Kühleinrichtung aufweist.

Die Aufgabe wird erfindungsgemäß gelöst, durch ein leistungselektronisches System mit den Merkmalen des Anspruchs 1, sowie durch ein Herstellungsverfahren für ein leistungselektronisches System mit den Merkmalen des Anspruchs 8. Bevorzugte Ausführungsformen sind in den jeweiligen abhängigen Ansprüchen beschrieben.

Das vorgestellte leistungselektronische System kann ausgebildet sein als ein Leistungshalbleitermodul mit einer Grundplatte, wobei diese Grundplatte die Funktion der Kühleinrichtung übernimmt und mit einer weiteren, meist effizienteren, Kühleinrichtung verbindbar ist. Diesbezüglich entspricht dies dem vielfältig bekannten Aufbau eines Leistungshalbleitermoduls mit externen Anschlusselementen, die in einem elektrisch isolierenden Gehäuse angeordneten sind und die Last- und Hilfsanschlüsse ausbilden

Ebenso kann das leistungselektronische System ausgebildet sein als ein grundplattenloses Leistungshalbleitermodul in Verbindung mit einer Kühleinrichtung. Ein derartiges Leistungshalbleitermodul weist ebenso ein Gehäuse und externe Anschlusselemente oben genannter Funktionalität auf.

Weiterhin kann das leistungselektronische System als ein Subsystem zum Aufbau einer größeren Einheit ausgebildet sein. Hierbei weist das System bevorzugt kein eigenes Gehäuse auf, wie es von den vorgenannten Leistungshalbleitermodulen bekannt ist. Die externen Anschlusselemente dienen hier entweder der internen Verbindung innerhalb der größeren Einheit oder auch zu deren externer Verbindung.

Die vorgenannten externen Anschlusselemente können hierbei auf verschiede Weise ausgebildet sein, wobei in einem leistungselektronischen System nicht nur eine dieser Ausgestaltungen vorgesehen sein kann.

Jegliche Ausgestaltung des erfindungsgemäßen leistungselektronischen Systems weist eine Mehrzahl von ersten flächigen Isolierstoffkörpern, die stoff- oder kraftschlüssig und voneinander beabstandet mit ihrer jeweiligen ersten Hauptfläche auf der Kühleinrichtung angeordnet sind. Diese vorzugsweise aus einem keramischen Werkstoff bestehenden Isolierstoffkörper dienen der elektrischen Isolation von Leistungshalbleiterbauelementen des leistungselektronischen Systems von dessen Kühlreinrichtung.

Zur Anordnung der Leistungshalbleiterbauelemente weist das leistungselektronische System erste Leiterbahnen auf, wobei erfindungsgemäß mindestens eine dieser ersten Leiterbahnen zwei erste Isolierstoffkörper auf deren zweiter Hauptfläche zumindest teilweise bedeckt. Die zweite Hauptfläche ist hierbei der ersten Hauptfläche gegenüberliegend angeordnet, wodurch die ersten Leiterbahnen auf der der Kühlreinrichtung abgewandten Seite der ersten Isolierstoffkörper angeordnet sind.

Auf diesen ersten Leiterbahnen sind die Leistungshalbleiterbauelemente des leistungselektronischen Systems schaltungsgerecht angeordnet. Hierbei ist es bevorzugt, wenn die Leistungshalbleiterbauelemente fluchtend zu zugeordneten ersten Isolierstoffkörpern angeordnet sind und diese hierbei horizontal nicht überragen. Es ist somit bevorzugt einer kleinen Anzahl, ggf. auch nur einem Leistungshalbleiterbauelement einen eigenen ersten Isolierstoffkörper zuzuordnen über den die im Leistungshalbleiterbauelement erzeugte Verlustleistung zur Kühleinrichtung hin abgeführt werden kann.

Weitere schaltungsgerechte Verbindungen dieser Leistungshalbleiterbauelemente sind mittels mindestens einer internen Verbindungseinrichtung ausgebildet. Diese interne Verbindungseinrichtung ist bevorzugt als eine flexible Leiterplatte mit mindestens einer zweiten Leiterbahn ausgebildet. Alternativ oder zusätzlich können als interne Verbindungseinrichtungen Draht- oder Bandbondverbindung vorgesehen sein.

Ein Zwischenraum zwischen den ersten Isolierstoffkörpern wird durch die oben genannte erste Leiterbahn, konkret durch mindestens einen Verbindungsabschnitt dieser Leiterbahn, zumindest teilweise überdeckt. Dies bedeutet, dass der gesamte Abstand zwischen den beiden ersten Isolierstoffkörpern überdeckt wird, allerdings nicht zwangsläufig auf der gesamten Breite des einen oder anderen ersten Isolierstoffkörpers.

Zur Sicherstellung der elektrischen Isolation zwischen einem Verbindungsabschnitt einer ersten Leiterbahn, der einen derartigen Zwischenraum überdeckt, kann es vorteilhaft sein den Zwischenraum zwischen diesem Verbindungsabschnitt und der Kühleinrichtung durch einen Isolierstoff derart auszufüllen, dass er sich zumindest im Bereich der Überdeckung zwischen den Randbereichen der ersten Isolierstoffkörper erstreckt und jeweils an diese ersten Isolierstoffkörper anschließt. Es kann natürlich aus Gründen der elektrischen Isolation vorteilhaft sein diesen Isolierstoff nicht nur unmittelbar unterhalb des Verbindungsabschnitts sondern auch seitlich hiervon vorzusehen.

Dieser Isolierstoff kann hierbei ausgebildet sein als eine gelartige Flüssigkeit, wie sie vielfältig in Leistungshalbleitermodul beispielhaft zur internen Isolation eingesetzt wird. Diese Ausgestaltung weist den Vorteil eines guten Anschlusses an den entsprechenden Randbereich des ersten Isolierstoffkörpers auf.

Alternativ kann dieser Isolierstoff auch als ein zweiter Isolierstoffkörper, vorteilhaft aus einem komprimierbaren Stoff ausgebildet sein, der sich unter Druck an den entsprechenden Randabschnitt des ersten Isolierstoffkörpers anlegt.

Ebenso ist als Ausgestaltung des Isolierstoffs eine Kombination aus zweitem Isolierstoffkörper, nicht notwendigerweise ausgestaltet als nicht komprimierbarer Stoff, und gelartiger Flüssigkeit in bestimmten Einsatzgebieten vorteilhaft.

Der wesentliche Vorteil der erfindungsgemäßen Ausgestaltung eines leistungselektronischen Systems liegt in der weitgehenden mechanischen Entkopplung der Kühleinrichtung und des jeweiligen Leistungshalbleiterbauelements. Die ersten Leiterbahnen weisen, da sie typischerweise aus Kupfer bestehen, einen ähnlichen oder sogar gleichen Ausdehnungskoeffizienten auf wie die Kühleinrichtung, die typisch aus Aluminium oder Kupfer besteht. Demgegenüber weisen die ersten Isolierstoffkörper und die Leistungshalbleiterbauelemente einen wesentlich kleineren Ausdehnungskoeffizienten auf. Durch die Ausbildung des Substrats bestehend aus ersten Leiterbahnen und einer Mehrzahl voneinander beanstandeter erster Isolierstoffkörper sind im Rahmen thermischer Ausdehnung die Leistungshalbleiterbauelement von der Kühleinrichtung mechanisch weniger starr verbunden als aus dem Stand der Technik bekannt. Hierdurch werden die Verbindungen der jeweiligen Komponenten weniger stark mechanisch belastet und erzielen eine größere Dauerhaltbarkeit. Gleichzeit ist die thermische Ankopplung der Leistungshalbleiterbauelemente zur Kühleinrichtung nicht zuletzt auf Grund der bevorzugten Sinterverbindungen annährend optimal.

Erfindungsgemäß wird ein derartiges leistungselektronisches System mittels folgender wesentlicher Schritte hergestellt:
a) Bereitstellen eines Kühlkörpers, vorzugsweise in einer der oben beschriebenen Ausgestaltungen;
b) Anordnen der ersten Isolierstoffkörper mit ihren ersten Hauptflächen auf dem Kühlkörper; vorteilhafterweise schließt sich nun direkt das Anordnen des mindestens einen Isolierstoffes an;
c) Anordnen der ersten Leiterbahnen auf den Isolierstoffkörpern, derart, dass mindestens eine erste Leiterbahn zwei erste Isolierstoffkörper auf deren zweiter Hauptfläche zumindest teilweise bedeckt und einen Zwischenraum zwischen den ersten Isolierstoffkörpern mit mindestens einem Verbindungsabschnitt überdeckt;
d) Anordnen des mindestens eine Leistungshalbleiterbauelements auf einer ersten Leiterbahn;
e) Anordnen der mindestens einen internen Verbindungseinrichtung.

Vorteilhafterweise werden diese Schritte entweder in der gegeben Reihenfolge, oder in der Reihenfolge a), b), d), c), e) ausgeführt. Falls der Isolierstoff ausschließlich aus einer gelartigen Flüssigkeit besteht kann diese auch noch zu einem späteren Zeitpunkt des Herstellungsprozesses angeordnet werden. Es ist nämlich bekannt derartige Flüssigkeiten derart auszubilden, dass sie in einem Zustand geringer Viskosität vorliegen und erst durch thermisches oder anderweitiges Einleiten einer Vernetzung die Viskosität steigt und sich der gelartige Zustand ausbildet.

Grundsätzlich ist es vorteilhaft alle Verbindungen zweier Verbindungspartner des leistungselektronischen Systems mit Ausnahme derjenigen zwischen dem Kühlkörper und den ersten Isolierstoffkörpern als stoffschlüssige Verbindungen auszubilden. Für diese Verbindung zwischen dem Kühlkörper und den ersten Isolierstoffkörpern ist eine kraftschlüssige Verbindung ebenso geeignet wie eine stoffschlüssige.

Eine derartig kraftschlüssige Verbindung entsteht fachüblich durch eine Druckeinleitung auf den ersten Isolierstoffkörper. Der Druck kann hierbei direkt auf den Isolierstoffkörper, über eine erste Leiterbahn oder auch über diese und weitere Komponenten eingeleitet werden.

Als stoffschlüssige Verbindung eignen sich verschiedene Ausgestaltungen von Lotverbindungen, wie auch bevorzugt Sinterverbindungen wegen ihrer hervorragenden mechanischen und thermischen Belastbarkeit, Dauerhaltbarkeit und Stromtragfähigkeit. Zur Ausbildung derartiger Sinterverbindungen ist es fachüblich an den Verbindungsstellen der Verbindungspartner eine Edelmetalloberfläche vorzusehen, zwischen den beiden Verbindungsstellen eine edelmetallhaltige Sinterpaste anzuordnen, und die Verbindungspartner unter hohem Druck und moderater Temperatur zu verbinden. In aktuellen Ausbildungen dieser Sintertechnik werden auch mehrere Verbindungen, hier beispielhaft diejenige der Leistungshalbleiterbauelement mit den ersten Leiterbahnen und mit einer internen Verbindungseinrichtung in Form einer flexiblen Leiterplatte, gleichzeitig ausgebildet. Es kann allerdings ebenso vorteilhaft sein andere Kombinationen von Verbindungspartnern für eine gleichzeitige Verbindung auszuwählen.

Die erfinderische Lösung wird an Hand der Ausführungsbeispiele gemäß den Fig. 1 bis 5 weiter erläutert.

Fig. 1 zeigt eine typische Schaltungsanordnung, die mittels eines oder mehrerer erfindungsgemäßer leistungselektronischer Systeme ausbildbar ist.

Fig. 2 bis 4 zeigen Phasen eines erfindungsgemäßen Herstellungsverfahrens.

Fig. 5 zeigt ein erfindungsgemäßes leistungselektronisches System.

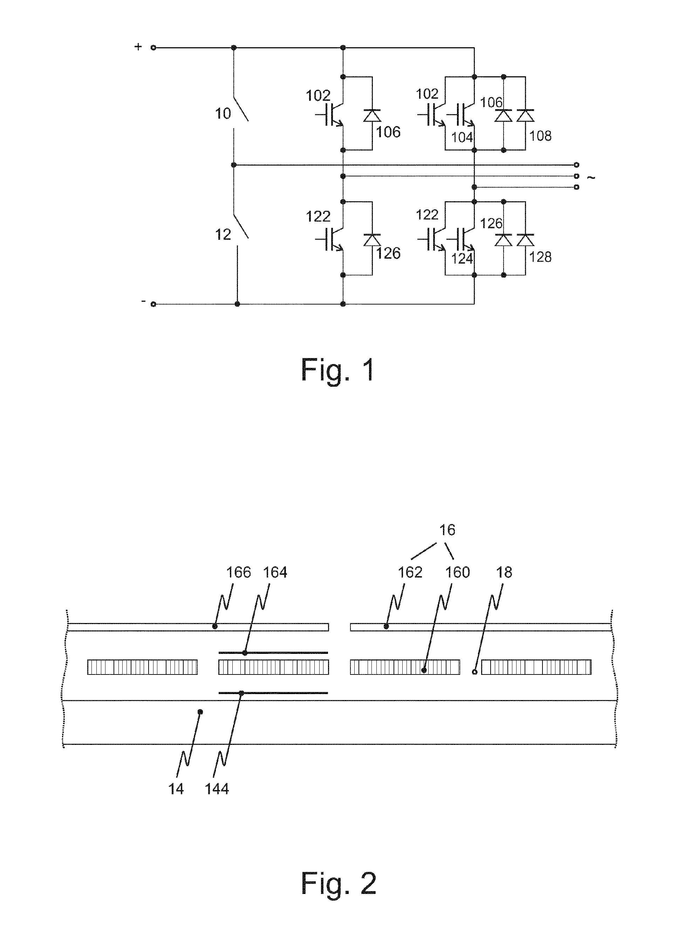

Fig. 1 zeigt eine typische Schaltungsanordnung, eine Drei-Phasen Brückenschaltung, die mittels eines oder mehrerer erfindungsgemäßer leistungselektronischer Systeme ausbildbar ist. Die einzelnen drei Halbbrücken dieser Drei-Phasen Brückenschaltung sind hier unterschiedlich detailliert dargestellt.

Die erste, linke Halbbrückenschaltung zeigt eine allgemeine Darstellung, mit einem ersten, oberen, auch "TOP" genannten, Leistungsschalter 10 und einem zweiten, unteren, auch "BOT", genannten Leistungsschalter 12. Diese Leistungsschalter 10, 12 sind mit einer Gleichspannungsquelle verbunden, während ihre Mittelanzapfung den Wechselspannungsausgang der ersten Phase bildet.

In den weiteren Halbbrückenschaltungen sind verschiedene konkretere Ausgestaltungen dargestellt. Beispielhaft kann ein Leistungsschalter 10, 12 als ein Leistungstransistor 102, 122 mit einer antiparallel geschalteten externen oder intrinsischen Leistungsdiode 106, 126 ausgebildet sein. Ebenso sind eine Mehrzahl dieser Varianten zur Ausbildung eines Leistungsschalters vorsehbar. Beispielhaft sind hier zwei Leistungstransistoren 102, 104, 122, 124 und zwei Leistungsdioden 106, 108, 126, 128 für den oberen 10 und den unteren Leistungsschalter 12 vorgesehen.

Ein erfindungsgemäßes leistungselektronisches System kann nun mindestens eines, aber auch alle drei dieser oben genannten Halbbrückenschaltungen gleichzeitig ausbilden. Grundsätzlich sind auch anderen Schaltungstopologien, wie beispielhaft Gleichspannungsbrücken oder Multilevelbrückenschaltungen mit mehr als zwei Leistungsschaltern je Brückenschaltung ausbildbar.

Fig. 2 bis 4 zeigen Phasen eines erfindungsgemäßen Herstellungsverfahrens. Fig. 2 zeigt schematisch in einem Ausschnitt eine Phase der Herstellung eines leistungselektronischen Systems. Dargestellt ist eine Kühleinrichtung 14, eine Mehrzahl von ersten Isolierstoffkörpern 160 und erste Leiterbahnen 162.

Die ersten Hauptflächen der Isolierstoffkörper 160 können mittels einer Drucksinterverbindung mit der Kühleinrichtung 14 verbunden werden. Dies ist hier angedeutet durch eine Lage aus einer Sinterpaste 144. Zu Ausbildung dieser Sinterverbindung ist es selbstverständlich alle notwendigen fachüblichen Maßnahmen vorzusehen. Bekannt ist es beispielhaft auf den zu verbindenden Oberflächen eine nicht dargestellte Edelmetallschicht vorzusehen. Alternativ ist es auch möglich, hier allerdings nicht dargestellt, dass die Verbindung zwischen der Kühleinrichtung 14 und den ersten Isolierstoffkörpern 160 als kraftschlüssige Verbindung ausgebildet ist.

Die Verbindung der zweiten Hauptflächen der ersten Isolierstoffkörper 160 mit ersten Leiterbahnen 162 erfolgt hier ebenfalls mittels einer Sinterverbindung, schematisch angedeutet durch die zugehörige Sinterpaste 164.

In diesem Ausschnitt werden somit jeweils zwei erste Isolierstoffkörper 160 mit einer gemeinsamen ersten Leiterbahn 162, konkret mittels deren Verbindungsabschnitt, zu einem Substrat 16 verbunden. In dieser Ausgestaltung, aber nicht notwendigerweise, bedeckt diese erste Leiterbahn 162 die zugeordneten zweite Hauptflächen der ersten Isolierstoffkörper 160 vollständig.

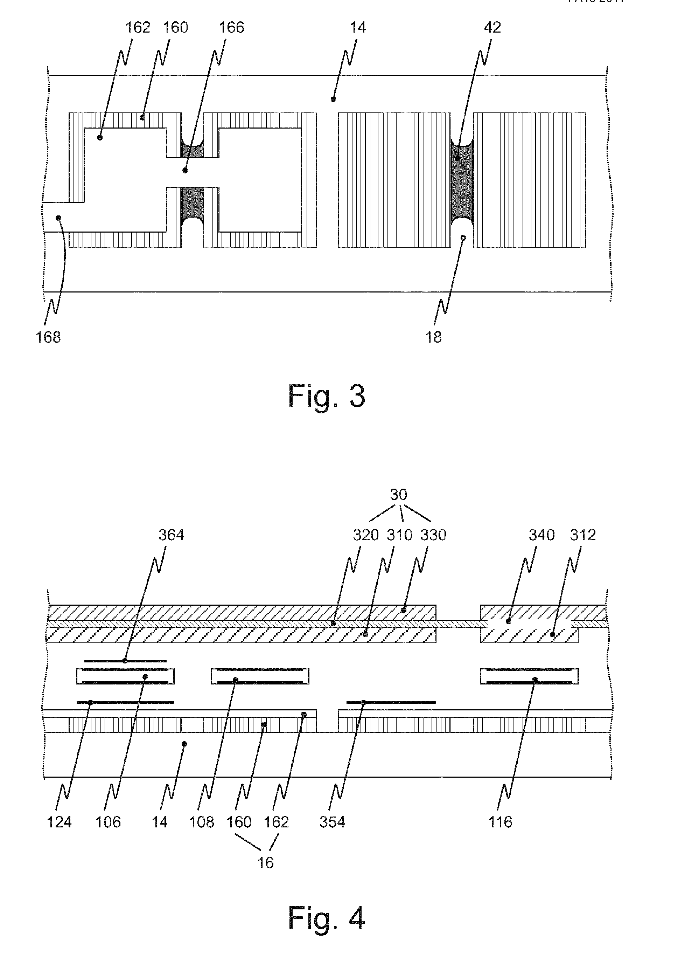

Zudem wird mittels des Verbindungsabschnitts 166 der ersten Leiterbahn 162 jeweils ein Zwischenraum 18 zwischen benachbarten Isolierstoffkörpern 160 überdeckt. Fig. 3 zeigt zur weiteren Erläuterung dieser Überdeckung eine Draufsicht auf eine der Fig. 2 sehr ähnliche Ausgestaltung.

Unterschiedlich ist hier, dass nur eine erste Leiterbahn 162 dargestellt ist und diese die zugeordneten ersten Isolierstoffkörper 162 nicht vollständig bedeckt sondern teilweise einen Rand freispart. Im Bereich der Verbindung zwischen den beiden zugeordneten ersten Isolierstoffkörpern 160 wird hier ersichtlich, dass selbstverständlich der gesamt Abstand des Zwischenraumes 18 zwischen den ersten Isolierstoffkörpern 160 überdeckt wird. Allerdings erfolgt diese Überdeckung mittels des Verbindungsabschnitts 166 nicht notwendigerweise über die gesamte Längsausdehnung der ersten Isolierstoffkörper 162.

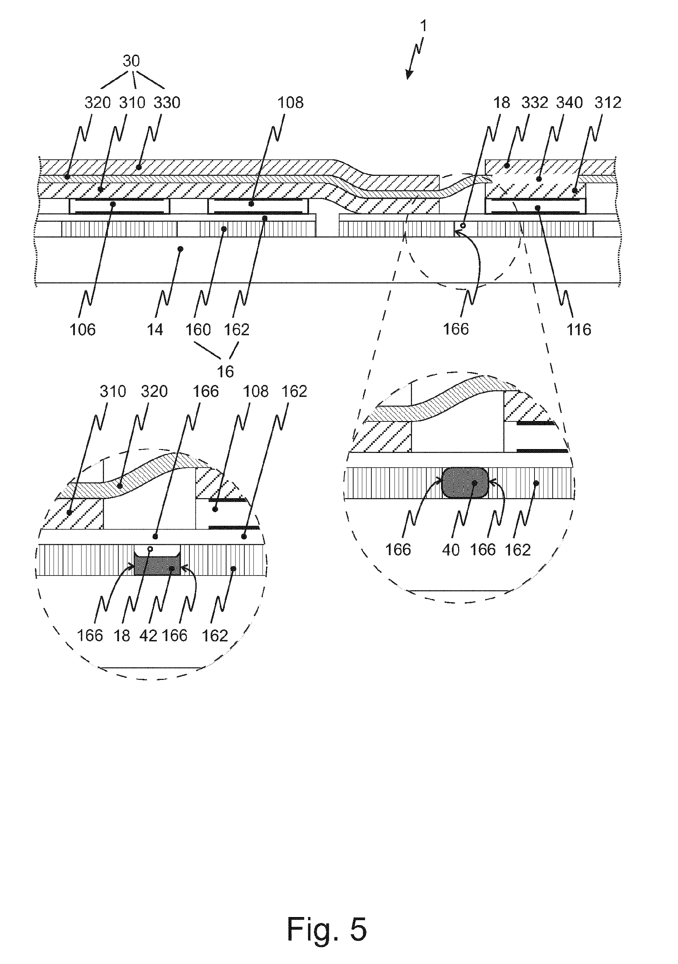

Zudem ist hier ein zusätzlicher Isolierstoff 42 dargestellt der (vgl. Fig. 5) im Zwischenraum 18 zwischen den ersten Isolierstoffkörpern 160 und unterhalb des Verbindungsabschnitts 166 der ersten Leiterbahn 162 angeordnet ist. Hierbei erstreckt sich dieser Isolierstoff 42 zwischen den Randbereichen 166 der jeweiligen ersten Isolierstoffkörper 162. Weiterhin ist dieser Isolierstoff 42 nicht nur fluchtend zu dem ihm zugeordneten Verbindungsabschnitt 166 sondern auch seitlich hiervon vorgesehen um die elektrische Isolierung zwischen dem Verbindungsabschnitt 166 und der Kühleinrichtung 14 sicher zu stellen.

In der dargestellten Ausgestaltung sind hier mehrere einzelne Isolierstoffe 42 jeweils zwischen ersten Isolierstoffkörpern 162 vorgesehen. Hierbei sind diese Isolierstoffe 42 vorteilhafterweise ausgebildet als eine gelartige Flüssigkeit, deren erforderliche Viskosität erst nach Anordnung eingestellt wird. Alternativ oder zusätzlich kann als Isolierstoff ein zweiter Isolierstoffkörper vorgesehen sein, der vorzugsweise ein oder mehrere erste Isolierstoffkörper an ihren Rändern zumindest abschnittweise umschließt.

Zudem kann die erste Leiterbahn 162 weitere Abschnitte 168 aufweisen, die in ihrem weiteren Verlauf als externes Anschlusselemente dienen oder mit einem externen Anschlusselement direkt verbunden sind.

Fig. 4 zeigt eine spätere Phase des Herstellungsverfahrens. Hierbei sind die ersten Leiterbahnen 162 mit den ersten Isolierstoffkörpern 160 verbunden dargestellt. Dieser Verbund bildet somit das Substrat 16 aus. Dieses Substrat 16 ist mit der Kühleinrichtung 14 kraft- oder stoffschlüssig verbunden und dient der Anordnung der Leistungshalbleiterbauelemente 106, 108, 116. Vorzugsweise sind diese ebenfalls mittels einer Sinterverbindung mit den ersten Leiterbahnen 162 verbunden. Dies ist schematisch durch eine zugehörige Sinterpaste 124 angedeutet.

Weiterhin dargestellt ist eine interne Verbindungseinrichtung 30 in Ausgestaltung einer flexiblen Leiterplatte, die beispielhaft als Folienverbund aus elektrisch leitenden 310, 312, 330 und elektrisch isolierenden Folien 320 ausgebildet sein kann. Diese flexible Leiterplatte stellt somit zweite und ggf. auch weitere Leiterbahnen bereit und kann im Bedarfsfall auch Durchkontaktierungen 340 durch isolierende Folien 320 aufweisen.

In der dargestellten Ausgestaltung verbindet eine derartige zweite Leiterbahn 310 zwei auf einer gemeinsamen ersten Leiterbahn 162 angeordnete Leistungshalbleiterbauelement 106 mit einer weiteren ersten Leiterbahn 162. Diese flexible Leiterplatte 30 wird wiederum mittels eine Sinterverbindung schaltungsgerecht mit Leistungshalbleiterbauelementen und mit ersten Leiterbahnen verbunden. Zur Verdeutlichung dieser Sinterverbindungen sind wiederum zugeordnete Sinterpasten 354, 364 schematisch dargestellt.

Grundsätzlich bieten sich zwei bevorzugt Reihenfolgen für die Ausbildung der jeweiligen Verbindungen an. Die erste Reihenfolge beginnt mit der Ausbildung des Verbundes aus Substrat 16 und Kühleinrichtung 14. In einem nächsten Schritt wird ein Verbund aus Leistungshalbleiterbauelementen 106, 108, 116 und interner Verbindungseinrichtung 30 ausgebildet. Abschließend werden die beiden Verbünde miteinander verbunden. Bei dieser Ausgestaltung kann es vorteilhaft sein, wenn alle Verbindungen als stoffschlüssige Verbindungen, insbesondere als Sinterverbindungen, ausgebildet sind.

Die zweite Reichenfolge beginnt mit der Ausbildung eines Substrats 16 also des Verbundes aus ersten Isolierstoffkörpern 160 und ersten Leiterbahnen 162, wobei die Leistungshalbleiterbauelemente 106, 108, 116 gleichzeitig oder im Anschluss mit den ersten Leiterbahnen 162 verbunden werden. Im Anschluss hieran wird dieser Verbund auf der Kühleinrichtung 14 angeordnet. Bei dieser Ausgestaltung kann es vorteilhaft sein, wenn alle Verbindungen mit Ausnahme derjenigen zwischen den ersten Isolierstoffkörpern 160 und der Kühleinrichtung 14 als stoffschlüssige Verbindungen ausgebildet sind. Diese Verbindung zwischen den ersten Isolierstoffkörpern 160 und der Kühleinrichtung 14 ist dann als kraftschlüssige, sog. Druckkontaktverbindung, ausgebildet. Die notwendigen internen Verbindungseinrichtungen 30 werden hierbei je nach deren Ausgestaltung beispielhaft vor Ausbildung der Druckkontaktverbindung angeordnet.

Fig. 5 zeigt einen Ausschnitt eines erfindungsgemäßen leistungselektronischen Systems mit einer Kühleinrichtung 14, hierauf angeordnet einem nicht einstückig ausgebildeten Substrat 16 bestehend aus einer Mehrzahl von ersten Isolierstoffkörpern 160, mit ersten Leiterbahnen 162. Dargestellt sind zwei erste Leiterbahnen 162, jede jeweils zwei Isolierstoffkörper 160 bedeckend und einen Zwischenraum 18 zwischen diesen Isolierstoffkörpern 160 mittels eines Verbindungsabschnitts 166 überdeckend.

In diesem Zwischenraum 18 ist an notwendigen Stellen ein Isolierstoff 40, 42 vorgesehen, der hier in den Ausschnittsvergrößerungen entweder als gelartige Flüssigkeit 42 oder als ein zweiter komprimierbarer Isolierstoffkörper 40 ausgebildet ist.

Die Leistungshalbleiterbauelemente 106, 108, 116 des leistungselektronischen Systems sind auf den ersten Leiterbahnen 162 schaltungsgerecht angeordnet und mittels einer als flexible Leiterplatte 30 ausgebildeten internen Verbindungseinrichtung schaltungsgerecht verbunden. Die interne Verbindungseinrichtung 30 und alternativ oder zusätzlich auch die ersten Leiterbahnen 162 können in ihrem nicht dargestellten weiteren Verlauf selbst externe Anschlusselemente ausbilden oder mit diesen verbunden sein.

## Patentansprüche

1. Leistungselektronisches System (1) mit einer Kühleinrichtung (14), einer Mehrzahl von ersten flächigen Isolierstoffkörpern (160), einer Mehrzahl von ersten Leiterbahnen (162), mindestens einem Leistungshalbleiterbauelement (102, 104, 106, 108, 122, 124, 126, 128) mindestens einer internen Verbindungseinrichtung (30) und externen Anschlusselementen, wobei
die Isolierstoffkörper (160) stoff- oder kraftschlüssig und voneinander beabstandet mit ihrer ersten Hauptfläche auf der Kühleinrichtung (14) angeordnet sind,
mindestens eine erste Leiterbahn (162) zwei erste Isolierstoffkörper (160) auf deren zweiter Hauptfläche zumindest teilweise bedeckt und einen Zwischenraum (18) zwischen den ersten Isolierstoffkörpern (160) mit mindestens einem Verbindungsabschnitt (166) überdeckt.

2. Leistungselektronisches System nach Anspruch 1, wobei
das mindestens eine Leistungshalbleiterbauelement (102, 104, 106, 108, 122, 124, 126, 128) fluchtend zu einem zugeordneten ersten Isolierstoffkörpers (160) angeordnet ist und diesen hierbei horizontal nicht überragt.

3. Leistungselektronisches System nach Anspruch 1, wobei
die ersten Isolierstoffkörper (160) aus einem keramischen Werkstoff bestehen.

4. Leistungselektronisches System nach Anspruch 1, wobei
mindestens ein durch einen Verbindungsabschnitt (166) einer ersten Leiterbahn (162) überdeckter Zwischenraum (18) zwischen ersten Isolierstoffkörpern (160) durch einen Isolierstoff (40, 42) derart ausgefüllt ist, dass er sich zumindest im Bereich der Überdeckung zwischen den Randbereichen (166) der ersten Isolierstoffkörper (160) erstreckt und jeweils an diese ersten Isolierstoffkörper (160) anschließend ausgebildet ist.

5. Leistungselektronisches System nach Anspruch 4, wobei
der Isolierstoff (40, 42) als ein zweiter Isolierstoffkörper (40) oder als eine gelartige Flüssigkeit 842) oder als Kombination dieser ausgebildet ist.

6. Leistungselektronisches System nach Anspruch 1, wobei
die mindestens eine interne Verbindungseinrichtung (30) als eine flexible Leiterplatte mit mindestens einer zweiten Leiterbahn (310, 312) ausgebildet ist.

7. Leistungselektronisches System nach Anspruch 1, wobei
die mindestens eine interne Verbindungseinrichtung (30) als eine Draht- oder Bandbondverbindung ausgebildet ist.

8. Herstellungsverfahren für ein leistungselektronisches System mit einer Kühleinrichtung (14), einer Mehrzahl von ersten flächigen Isolierstoffkörpern (160), einer Mehrzahl von ersten Leiterbahnen (162), mindestens einem Leistungshalbleiterbauelement (102, 104, 106, 108, 112, 124, 126, 128), mindestens einer internen Verbindungseinrichtung (30) und externen Anschlusselementen, bestehend aus den folgenden Arbeitsschritten
a) Bereitstellen eines Kühlkörpers (14);
b) Anordnen der ersten Isolierstoffkörper (160) mit ihren ersten Hauptflächen auf dem Kühlkörper (14);
c) Anordnen der ersten Leiterbahnen (162) auf den Isolierstoffkörpern (160), derart, dass mindestens eine erste Leiterbahn (162) zwei erste Isolierstoffkörper (160) auf deren zweiter Hauptfläche zumindest teilweise bedeckt und einen Zwischenraum (18) zwischen den ersten Isolierstoffkörpern (160) mit mindestens einem Verbindungsabschnitt (166) überdeckt;
d) Anordnen des mindestens eine Leistungshalbleiterbauelements (102, 104, 106, 108, 122, 124, 126, 128) auf einer ersten Leiterbahn (162);
e) Anordnen der mindestens einen internen Verbindungseinrichtung (30).

9. Herstellungsverfahren nach Anspruch 8, wobei
das Herstellungsverfahren in der Reihenfolge a) bis e) ausgeführt wird.

10. Herstellungsverfahren nach Anspruch 8, wobei
das Herstellungsverfahren in der Reihenfolge a), b), d), c), e) ausgeführt wird.

11. Herstellungsverfahren nach Anspruch 9 oder 10, wobei
im Anschluss an Herstellungsschritt b) ein Isolierstoff (40, 42) zwischen mindestens zwei ersten Isolierstoffkörpern (160) angeordnet wird.

12. Herstellungsverfahren nach Anspruch 8, wobei
zwischen dem Kühlkörper (14) und den ersten Isolierstoffkörpern (160) sowie zwischen den ersten Isolierstoffkörpern (160) und der mindestens einen ersten Leiterbahn (162) eine Sinterpaste (144, 164) vorgesehen ist und nach Herstellungsschritt c) diese Komponenten mittels einer Drucksintervorrichtung miteinander verbunden werden.

13. Herstellungsverfahren nach Anspruch 8, wobei
zwischen einer ersten Leiterbahn (162) und dem mindestens einen ersten Leistungshalbleiterbauelement (102, 104, 106, 108, 122, 124, 126, 128) eine Sinterpaste (124) vorgesehen ist und diese Komponenten in einer Drucksintervorrichtung miteinander verbunden werden.

14. Herstellungsverfahren nach Anspruch 8, wobei
zwischen dem mindestens einen ersten Leistungshalbleiterbauelement (102, 104, 106, 108, 122, 124, 126, 128) und einer als flexible Leiterplatte (30) ausgebildeten internen Verbindungseinrichtung an den vorgesehenen Kontaktstellen eine Sinterpaste (364) vorgesehen ist und diese Komponenten in einer Drucksintervorrichtung miteinander verbunden werden.
